(19) **Europäisches Patentamt / European Patent Office / Office européen des brevets**

(11) **EP 1 682 912 B1**

(12) **EUROPEAN PATENT SPECIFICATION**

(45) Date of publication and mention
of the grant of the patent:
**08.08.2007 Bulletin 2007/32**

(21) Application number: **03776896.7**

(22) Date of filing: **11.11.2003**

(51) Int Cl.:
**G01R 31/36** (2006.01)

(86) International application number:
**PCT/EP2003/012590**

(87) International publication number:
**WO 2005/045453 (19.05.2005 Gazette 2005/20)**

(54) **APPARATUS AND METHOD FOR FUEL CELL RESISTANCE TEST**

VORRICHTUNG UND VERFAHREN ZUR WIDERSTANDSPRÜFUNG BEI BRENNSTOFFZELLEN

APPAREIL ET PROCEDE POUR TEST DE RESISTANCE DE PILE A COMBUSTIBLE

(84) Designated Contracting States:
**AT BE BG CH CY CZ DE DK EE ES FI FR GB GR HU IE IT LI LU MC NL PT RO SE SI SK TR**

(43) Date of publication of application:
**26.07.2006 Bulletin 2006/30**

(73) Proprietor: **Ansaldo Fuel Cells S.p.A.**
**16152 Genova (IT)**

(72) Inventor: **DELLA MALVA, Silvio**
**I-16142 Genova (IT)**

(74) Representative: **Gervasi, Gemma**
**Notarbartolo & Gervasi GmbH,**
**Bavariaring 21**
**80336 München (DE)**

(56) References cited:
**EP-A- 1 349 228        US-A- 3 676 770**
**US-A- 4 181 885        US-A- 5 773 978**
**US-A1- 2003 016 048**

## Description

## Field of the invention

The present invention relates to a system applied for the measurement of the total ohmic internal resistance of fuel cells and stack of fuel cells.

The device is composed by an electronic load that causes a pulse short circuit in the sample. High current is in this way achieved exploiting the power produced by the electrochemical generator itself.

In order to avoid the cell damage and the arising of electrochemical phenomena, the short circuit must give up sharply once the measurement has done (pulse short circuit of typically 0.1-100 msec), but it have to last enough to await the end of reactance effect on the response. The noise effects on measurement errors are reduced by means of the high current obtained.

The device can generate current pulse trains with ON/OFF ratio and operating frequency settable by operator. This feature allows to simulate the power pick up when the stack is connected to a DC/AC converter and to measure its response and its electrical behaviour under these conditions.

## Background of the Invention

A fuel cell is a device that uses hydrogen (or hydrogen-rich fuel) and oxygen to create electricity by an electrochemical process.

A single fuel cell consists of an electrolyte sandwiched between two thin electrodes (a porous anode and cathode). While there are different fuel cell types, all work on the same principle: hydrogen, or a hydrogen-rich fuel, is fed to the anode where a catalyst separates hydrogen's negatively charged electrons from positively charged ions (protons).

At the cathode, oxygen combines with electrons and, in some cases, with species such as protons or water, resulting in water or hydroxide ions, respectively. For polymer exchange membrane (PEM) and phosphoric acid fuel cells, protons move through the electrolyte to the cathode to combine with oxygen and electrons, producing water and heat.

For alkaline, molten carbonate, and solid oxide fuel cells, negative ions travel through the electrolyte to the anode where they combine with hydrogen to generate water and electrons. The electrons from the anode side of the cell cannot pass through the membrane to the positively charged cathode; they must travel around it via an electrical circuit to reach the other side of the cell. This movement of electrons is an electrical current.

The amount of power produced by a fuel cell depends upon several factors, such as fuel cell type, cell size, the temperature at which it operates, and the pressure at which the gases are supplied to the cell. Still, a single fuel cell produces enough electricity for only the smallest applications. Therefore, individual fuel cells are typically combined in series into a fuel cell stack. A typical fuel cell stack may consist of hundreds of fuel cells.

Direct hydrogen fuel cells produce pure water as the only emission. This water is typically released as water vapor.

Fuel cell systems can also be fueled with hydrogen-rich fuels, such as methanol, natural gas, gasoline, or gasified coal. In many fuel cell systems, these fuels are passed through "reformers" that extract hydrogen from the fuel. Onboard reforming has several advantages:

First of all it allows the use of fuels with higher energy density than pure hydrogen gas, such as methanol, natural gas, and gasoline.
Further, it allows the use of conventional fuels delivered using the existing infrastructure (e.g., liquid gas pumps for vehicles and natural gas lines for stationary source).

High-temperature fuel cell systems can reform fuels within the fuel cell itself -a process called internal reforming- removing the need for a separate reformer and their associated costs. Internal reforming, however, does emit carbon dioxide, just like a separate reformer. In addition, impurities in the gaseous fuel can reduce cell efficiency.

The design of fuel cell systems is quite complex and can vary significantly depending upon fuel cell type and application. However, most fuel cell systems consist of four basic components:

- A fuel processor
- An energy conversion device (the fuel cell or fuel cell stack)
- A power converter
- Heat recovery system (typically used in high-temperature fuel cell systems used for stationary applications)

Other components and subsystems are foreseen to control fuel cell humidity, temperature, gas pressure, and wastewater.

The first component of a fuel cell system is the fuel processor. The fuel processor converts fuel into a form useable by the fuel cell. If hydrogen is fed to the system, a processor may not be required or it may be reduced to hydrogen storage and feeding systems.

If the system is powered by a hydrogen-rich conventional fuel such as methanol, gasoline, diesel, or gasified coal, a reformer is typically used to convert hydrocarbons into a gas mixture of hydrogen and carbon compounds called "reformate." In many cases, the reformate is then sent to another reactor to remove impurities, such as carbon oxides or sulfur, before it is sent to the fuel cell stack. This prevents impurities in the gas from binding with the fuel cell catalysts. This binding process is also called "poisoning" since it reduces the efficiency and life expectancy of the fuel cell.

Some fuel cells, such as molten carbonate and solid oxide fuel cells, operate at temperatures high enough that the fuel can be reformed in the fuel cell itself. This is called internal reforming.

Both internal and external reforming release carbon dioxide, but less than the amount emitted by internal combustion engines, such as those used in gasoline-powered vehicles, due to high conversion efficiency available with fuel cells.

Fuel cell systems are not primarily used to generate heat. However, since significant amounts of heat are generated by some fuel cell systems-especially those that operate at high temperatures such as solid oxide and molten carbonate systems-this excess energy can be used to produce steam or hot water or converted to electricity via a gas turbine or other technology. This increases the overall energy efficiency of the systems.

The fuel cell stack is the energy conversion device. It generates electricity in the form of direct current (DC) from chemical reactions that take place in the fuel cell. The purpose of current inverters and conditioners is to adapt the electrical current from the fuel cell to suit the electrical needs of the application, whether it is a simple electrical motor or a complex utility power grid.

If the fuel cell is used to power equipment using AC, the direct current will have to be converted to alternating current.

Both AC and DC power must be conditioned. Power conditioning includes controlling current flow, voltage, frequency, and other characteristics of the electrical current to meet the needs of the application.

Conversion and conditioning reduce system efficiency only slightly, around 2 to 6 percent.

A fuel cell in open circuit (i.e. when no current is generated) produces the ideal voltage described by the Nernst equation. Once the current is raised, the following losses take place:

• ohmic losses of the electrolyte, of metallic conductors and in the conductors contact zone;
• activation losses caused by the finite electrochemical reaction rates;
• diffusion losses due to the difficult mass exchange between gas bulk and reaction sites in the catalyst.

In order to measure the internal ohmic losses of a fuel cell, it is necessary to separate its contribution from the activation and the diffusion ones. Since the dynamic response of the former is much faster than the one of the others, ohmic resistance can be calculated by means of Ohm's law filled with current and voltage measured immediately after a stepwise closing of the circuit, when electrochemical factors haven't got the time for taking place.

In addition for fuel cell and fuel cell stacks of commercial interest, high current values are expected to be produced at low voltage. Typically currents range from few Amps on laboratory scale cells up to thousand Amps or more on full size stacks. The voltages across the cell are in any case around one Volt or lower (typically 0.5 - 1V) .

The needs of a measurement device that allows this wide current range-ability is fulfilled by the present invention.

In other kinds of devices developed in the prior art, the measurement is taken just after the opening of the circuit, or studying frequency response of the cell to sinusoidal shaped drive, thus giving only an approximate estimation of the value with many error sources.

Low internal resistance is one of the features of fuel cells, hence low voltages are expected to be measured through such a resistance. For this reason high accuracy (i.e. low noise influence on measurement) is reachable employing high current. This purpose has still not been achieved.

In fact, the literature indicates that many attempts in this direction led to the development of expensive benchtop laboratory equipment consisting of many sub-systems interfaced with -one another, just like what arises from J.R. Selman and Y.P.Lin work, "application of AC impedance in fuel cell research and development", or from the US patent 6,002,238 where an extremely complex theoretical and technical approach for the impedance measurement was used.

The US patent 3,676,770 discloses a measuring circuit which causes a pulse of energy having a regulated Ohm's law related first parameter to flow through an element whose resistance is to be measured.

In those and many other cases, the necessary accuracy of the measurement is always influenced by negatively conditioning technical and practical factors which sink the recovery and increase the application costs of the systems.

Scope of the Invention

The general object of the present invention is to measure with high accuracy and without the complications of the prior art the total internal resistance of fuel cells or fuel cells stack.

Furthermore, another object of the present invention is to provide an apparatus which allows the measurement of a single pulse and of a train of pulses in order to simulate with effectiveness the fuel cell behaviour when this is connected to a DC/AC inverter.

The above mentioned features are achieved by means of an apparatus according to claim 1 and by a corresponding method according to claim 5.

The measurement system according to the present invention comprises:

an electronic load system which comprises

- an input unit generating an input pulse
- a driver for the control of the input pulse
- a MOSFET module comprising at least one MOSFET device for the generation of a short circuit in a fuel cell

- a bank of selectable resistors

and a measuring circuit which comprises

- a shunt for converting the fuel cell current into a voltage signal
- differential amplifiers for the current and the voltage signals
- a data acquisition system which receives the voltage and the current signals obtained by the differential amplifiers.

As already cited above, due to the low internal resistance of fuel cells, high current pulse is employed for obtaining high accuracy of the measurement. This feature is very important for the application on single fuel cell test, where low voltages are delivered.

The power produced by the sample fuel cell itself is exploited for this purpose causing a temporary short circuit from the open circuit condition. The endurance of short circuit must be long enough for awaiting the end of reactance effect on the response, and at the same time short enough to avoid cells damage and the arising of electrochemical phenomena, such as polarization or diffusion.

A typical range of 0.1-100 msec was found as suitable for the measurement purpose. For its high action speed, a low resistance MOSFET module comprising at least one MOSFET device is employed in order to obtain the sharpest short circuit pulse. The number of MOSFET devices in the module can be changed in order to modify the pulse range.

The MOSFET (Metal Oxide Silicon Field Effect Transistor) is a device that controls a current between two contacts (Source and Drain) using a voltage contact (Gate). The device uses a surface effect to create a n-type region in a p-type substrate (or the converse).

When considering a simple capacitor structure using a p-type substrate, an oxide layer and a metal gate, by applying a positive potential to the gate (the substrate is grounded) electrons will be attracted to the gate and will pile up at the surface underneath the gate.

At some voltage $V_{th}$ called the threshold voltage, the region under the gate will have enough additional electrons that $n > p$ and the material will be n-type not p-type. The oxide is very important as it stops the current flow towards the gate and forces the electrons to "pile up" underneath the gate and turn the material n-type.

This basic MOSFET structure uses the capacitor structure with n-type regions placed at either edge, known as the source and drain.
The basic operation of the device is to bias the gate with $V_G > V_{th}$ and form a n-type region between the source and the drain. This provides a simple n-type path between the n-type source and drain regions for electrons to flow. This region is called a channel. It is to note that without forming the channel there are two back to back diodes formed which will not allow appreciable current to flow. The formation of this channel provides a simple resistive path between the source and the drain. The thickness of the channel is function of the difference between the gate potential and the potential in the substrate near the surface.

By placing a voltage between the source and the drain and thus causing a current to flow, the source will be typically grounded and the drain biased with $V_{DS}$. The ability to change the thickness of the channel using the gate potential provides a means of controlling the current from the source to the drain, so that a voltage controlled resistor can be basically formed.

One thing to note is that the application of a drain voltage raises the potential of the region of the substrate at the surface near the drain. This results in a thinner channel at that end (as the gate to substrate potential is reduced).

A new condition arises if the drain voltage is increased substantially ($V_{DS} > V_{DS,sat}$ where $V_{DS,sat}$ is called the saturation voltage). The drain voltage becomes large enough that the gate to substrate potential at the drain is smaller than threshold. Therefore the channel thickness at this end goes to zero. This is called *pinch off*. Electrically, the effect of *pinch off* is that the channel no longer acts like a simple resistor. The current $I_{DS}$ becomes fixed (saturated) at the value just prior to *pinch off*.

Therefore the equations for the MOSFET are:

- the triode region: $V_{GS} > V_{th}$, $V_{DS} < V_{DS,sat}$

$$I_{DS} = I_0 \left[ (V_{GS} - V_{th}) V_{DS} - V_{DS}^2/2 \right]$$

the $V_{DS}^2/2$ term takes the narrowing of the channel at the gate region into account as $V_{Ds}$ approaches $V_{Ds,sat}$.

- the saturation region: $V_{GS} > V_{th}$, $V_{DS} > V_{DS,sat}$ It can be shown that

$$V_{DS,sat} = V_{GS} - V_{th}$$

and

$$I_{DS,sat} = I_0 \frac{(V_{GS} - V_{th})^2}{2}$$

In saturation the MOSFET acts like a nonlinear voltage controlled current.

The MOSFET module is characterised by very fast response to the driver signal, hence its ability to close and open very sharply the circuit.

It's also important that the MOSFET module has a low resistance, because high currents at low voltage are wished.

Another important feature of this component is that it remains activate even if very low voltage is applied. In particular the MOSFET module can work with voltage below 0.5 Volt. This voltage level is not attainable using different electronic devices like BJT, GTO, IGBT used on commercial devices for similar applications. The limit of commercial devices to make measurement only at higher voltages is eliminated by this invention.

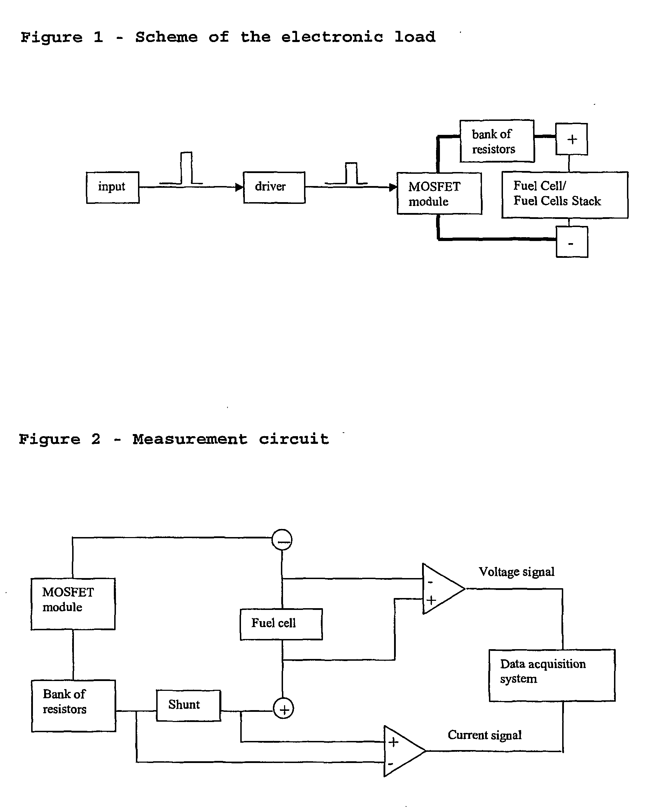

As it can be seen in the figures 1 and 2, the system comprises an electronic load and a measuring/data acquisition unit.

The former, illustrated in fig. 1, has an input unit which generates a settable time range pulse; next there's a driver that fits the input pulse for piloting the MOSFET; this one finally causes the short circuit in the fuel cell.

The use of current or voltage driven electronic load was discarded because it causes feedback on the circuit affecting output measurement, hence the resistance is going to be fixed and both current and voltage are going to be measured.

The speed of response of the circuit, which is equivalent to RLC series, depends on its total resistance: the higher is the resistance, the lower is the time constant of the circuit and consequently the reactance effect on response.

In order to enhance this feature, in series with the fuel cell, there's a bank of selectable shunt resistors.

Anyway, high resistance reduces the current and consequently the accuracy of the measurement.

Therefore the resistance has to be selected as a compromise between wanted speed of response and accuracy. All connections and resistors are chosen to be low inductive. Load elements are connected to a safety system that limits current when local temperatures become too high.

In order to obtain the desired internal resistance value, the fuel cell is then connected with a measurement apparatus.

Figure 2 represents a simplified scheme of this measuring circuit. Here a shunt is used for obtaining the value of the current by means of voltage measurement at its ends. This value is sent to a data acquisition system by means of a differential amplifier. The voltage, instead, is directly measured at the two ends of the fuel cell and, as for the current signal, also in this case a differential amplifier sends the voltage signal to the acquisition system.

Active differential probe are included in all the signal connection in order to reduce the ambient noises. They must also amplify the signal (typically gain is more than 10), because, differently from the usual application, source voltages to be transmitted are low.

The system described can be applied also for evaluating the fuel cell behaviour when connected to a DC/AC inverter. For this purpose a series of current pulses can be generated in the fuel cells, ON/OFF time ratio and operating frequency can be set by operator within a wide range.

Another important advantage of the present invention is given by the fact that normally, the driving energy needed for step current transition comes from an external source, thus complicating the whole system and causing several problems regarding the optimisation of effectiveness of the process. With the present system, on the contrary, the internal energy available inside the fuel cell can be exploited.

## Claims

1. Apparatus for the measurement of the total internal resistance of fuel cells and fuel cells stacks comprising an electronic load system which comprises

   - an input unit generating an input pulse
   - a driver for the control of the input pulse
   - a MOSFET module comprising at least one MOSFET device for the generation of a short circuit in a fuel cell
   - a bank of selectable resistors connected in series to the MOSFET

   and a measuring circuit which comprises:

   - a shunt which is in series with the bank of resistors, for converting the fuel cell voltage into a current signal
   - differential amplifiers for the current and the voltage signals
   - a data acquisition system which receives the voltage and the current signals obtained by the differential amplifiers.

2. Apparatus according to claim 1,
   **characterised in that** said MOSFET module produces short circuit pulses of 0.1 to 100 msec.

3. Apparatus according to claim 1 or 2
   **characterised in that** the bank of selectable resistors is connected in series with the fuel cell.

4. Apparatus according to the claims 1 to 3,
   **characterised in that** active differential probes are included in all the signal connections for the reduction of ambient noises.

5. Apparatus according to the claims 1 to 4,
   **characterised in that** all connections and resistors are low inductive.

6. Apparatus according to the claims 1 to 5,

**characterised in that** the load elements are connected to a safety system that limits current when local temperatures become too high.

7. Method for the measurement of the total internal resistance of fuel cells and fuel cells stacks comprising the following steps:

- generating an input pulse
- causing a short circuit in the fuel cell by means of a MOSFET module
- taking the potential measurement of the cell for resistance calculation when the circuit gets closed
- obtaining the cell current signal by means of a shunt
- sending the voltage and the current signals to an acquisition system.

8. Method according to claim 7,
**characterised in that** the reactance effect on response is enhanced by a bank of resistors.

9. Method according to claim 7 or 8,
**characterised in that** the MOSFET module remains active even by the application of the voltage of a single fuel cell.

10. Method according to the claims 7 to 9,
**characterised in that** the noise effects on measurement errors are reduced by means of the high current obtained.

11. Method according to the claims 7 to 10,
**characterised in that** current pulse trains are generated with ON/OFF ratio and operating frequency settable by operator.

**Patentansprüche**

1. Apparatur zur Messung des gesamten Innenwiderstandes von Brennstoffzellen und Brennstoffzellenstapeln, wobei diese Apparatur ein elektronisches Belastungssystem umfasst, zu welchem gehören:

-- eine Eingangseinheit, welche einen Eingangsimpuls erzeugt,

- ein Treiber zur Steuerung des Eingangsimpulses,
- ein MOSFET-Modul, welcher mindestens ein MOSFET-Bauteil zur Erzeugung eines Kurzschlusses in einer Brennstoffzelle enthält,
- ein Satz von auswählbaren Widerständen, die mit dem MOSFET in Reihe geschaltet sind,

sowie einen Messstromkreis, zu welchem gehören:

- ein mit dem Satz von Widerstanden in Reihe liegender Nebenschlusswiderstand, um den Brennstoffzellenstrom in ein Spannungssignal umzuwandeln,
- Differenzverstärker für die Strom- und Spannungssignale,
- ein Datenerfassungssystem, welches die von den Differenzverstärkern erhaltenen Spannungs- und Stromsignale aufnimmt.

2. Apparatur nach Anspruch 1 , **dadurch gekennzeichnet, dass** der genannte MOSFET-Modul Kurzschlussimpulse von 0,1 bis 100 ms Dauer erzeugt.

3. Apparatur nach Anspruch 1 oder 2, **dadurch gekennzeichnet, dass** der Satz von auswählbaren Widerständen mit der Brennstoffzelle in Reihe geschaltet ist.

4. Apparatur nach Anspruch 1 bis 3, **dadurch gekennzeichnet, dass** aktive Differentialsonden in allen Signalleitungen enthalten sind, um das Rauschen bzw. die Umgebungsgeräusche zu senken.

5. Apparatur nach Anspruch 1 bis 4, **dadurch gekennzeichnet, dass** alle Verbindungen und Widerstände eine geringe Induktivität aufweisen.

6. Apparatur nach Anspruch 1 bis 5, **dadurch gekennzeichnet, dass** die Lastelemente an ein Sicherheitssystem angeschlossen sind, welches den Strom begrenzt, wenn die örtlichen Temperaturen zu hoch werden.

7. Verfahren zur Messung des gesamten Innenwiderstandes von Brennstoffzellen und Brennstoffzellenstapeln, welches die folgenden Schritte umfasst:

- Erzeugung eines Eingangsimpulses,
- Hervorrufen eines Kurzschlusses in der Brennstoffzelle mittels eines MOSFET-Moduls,
- Durchführung der Potentialmessung der Zelle zur Berechnung des Widerstandes, wenn der Stromkreis geschlossen wird,
- Gewinnung des Zellenstromsignals mittels eines Nebenschlusswiderstandes,
- Übermittlung des Spannungs- und Stromsignals an ein Datenerfassungssystem.

8. Verfahren nach Anspruch 7, **dadurch gekennzeichnet, dass** der Reaktanzeffekt auf das Antwortverhalten durch einen Satz von Widerständen verbessert wird.

9. Verfahren nach Anspruch 7 oder 8, **dadurch ge-**

**kennzeichnet, dass** der MOSFET-Modul selbst beim Anliegen der Spannung einer einzigen Brennstoffzelle aktiv bleibt.

10. Verfahren nach Anspruch 7 bis 9, **dadurch gekennzeichnet, dass** die Einflüsse des Rauschens auf die Messfehler durch die erhaltene hohe Stromstärke vermindert werden.

11. Verfahren nach Anspruch 7 bis 10, **dadurch gekennzeichnet, dass** Stromimpulsketten erzeugt werden, deren Ein/Aus-Verhältnis und Betriebsfrequenzen durch die Bedienperson eingestellt werden können.

## Revendications

1. Appareil de mesure de la résistance interne totale de piles à combustible et d'empilements de piles à combustible comprenant un système de charge électronique qui comprend

    - une unité d'entrée générant une impulsion d'entrée
    - un dispositif d'entraînement destiné à contrôler l'impulsion d'entrée
    - un module MOSFET comprenant au moins un dispositif MOSFET destiné à la génération d'un court-circuit dans une pile à combustible
    - une banque de résistances sélectionnables reliées en série au MOSFET

et un circuit de mesure qui comprend :

    - un shunt qui est en série avec la banque de résistances, afin de convertir la tension de la pile à combustible en un signal de courant
    - des amplificateurs différentiels destinés aux signaux de courant et de tension
    - un système d'acquisition de données qui reçoit les signaux de tension et de courant obtenus par les amplificateurs différentiels.

2. Appareil selon la revendication 1, **caractérisé en ce que** ledit module MOSFET produit des impulsions de court-circuit de 0,1 à 100 millisecondes.

3. Appareil selon la revendication 1 ou 2 **caractérisé en ce que** la banque de résistances sélectionnables est reliée en série avec la pile à combustible.

4. Appareil selon les revendications 1 à 3, **caractérisé en ce que** des sondes différentielles actives sont incluses dans l'ensemble des connexions de signaux afin de réduire les bruits ambiants.

5. Appareil selon les revendications 1 à 4, **caractérisé en ce que** l'ensemble des connexions et des résistances sont faiblement inductives.

6. Appareil selon les revendications 1 à 5, **caractérisé en ce que** les éléments de charge sont reliés à un système de sécurité qui limite le courant lorsque les températures locales deviennent trop élevées.

7. Procédé de mesure de la résistance interne totale de piles à combustible et d'empilements de piles à combustible comprenant les étapes suivantes :

    - la génération d'une impulsion d'entrée
    - la provocation d'un court-circuit dans la pile à combustible à l'aide d'un module MOSFET
    - la mesure du potentiel de la pile afin de calculer la résistance lorsque le circuit est fermé
    - l'obtention du signal de courant de la pile à l'aide d'un shunt
    - l'envoi des signaux de tension et de courant à un système d'acquisition.

8. Procédé selon la revendication 7, **caractérisé en ce que** l'effet de réactance sur la réponse est amélioré par une banque de résistances.

9. Procédé selon la revendication 7 ou 8, **caractérisé en ce que** le module MOSFET reste actif même par l'application de la tension d'une seule pile à combustible.

10. Procédé selon les revendications 7 à 9, **caractérisé en ce que** les effets du bruit sur les erreurs de mesure sont réduits à l'aide du courant élevé obtenu.

11. Procédé selon les revendications 7 à 10, **caractérisé en ce que** des trains d'impulsions de courant sont générés avec un rapport ON/OFF et une fréquence d'exploitation définissables par un opérateur.

**Figure 1 - Scheme of the electronic load**

**Figure 2 - Measurement circuit**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6002238 A
- US 3676770 A